Europäisches Patentamt

European Patent Office

Office européen des brevets

(11) Publication number: **0 023 408**
**B1**

# EUROPEAN PATENT SPECIFICATION

(45) Date of publication of patent specification: **13.02.85**

(51) Int. Cl.⁴: **G 11 C 11/40**

(21) Application number: **80302483.5**

(22) Date of filing: **22.07.80**

(54) Semiconductor memory device including integrated injection logic memory cells.

(30) Priority: **26.07.79 JP 95346/79**
**27.07.79 JP 95697/79**

(43) Date of publication of application:
**04.02.81 Bulletin 81/05**

(45) Publication of the grant of the patent:
**13.02.85 Bulletin 85/07**

(84) Designated Contracting States:
**DE GB NL**

(56) References cited:
**US-A-4 078 261**

**I.B.M. TECHNICAL DISCLOSURE BULLETIN,**
**vol. 21, no. 10, March 1979, NEW YORK (US),**
**BERANGER e.a.: "Read and write circuits for a**
**harper cell memory", pages 4066-4067**
**IEEE Transactions on Electron Devices, vol.**
**ED-26, no. 6, June 1979, "A 4 k-bit Static I2 L**
**Memory", pages 886-892**

(73) Proprietor: **FUJITSU LIMITED**
**1015, Kamikodanaka Nakahara-ku**
**Kawasaki-shi Kanagawa 211 (JP)**

(72) Inventor: **Toyoda, Kazuhiro**
**39-1433, Sakuradai**
**Midori-ku, Yokohama-shi Kanagawa 227 (JP)**

(74) Representative: **Abbott, Leonard Charles et al**
**GILL JENNINGS & EVERY 53-64 Chancery Lane**
**London WC2A 1HN (GB)**

Courier Press, Leamington Spa, England.

## Description

The present invention relates to a semiconductor device and, more particularly, to a semiconductor integrated circuit device in which memory cells are of an $I^2L$ (which is an abbreviation for Integrated Injection Logic) type.

In general, each of the memory cells of a bipolar memory device comprises a pair of load transistors connected to one word line, a pair of cross-coupled transistors, connected to the load transistors, respectively, to one hold line and to a pair of bit lines, which serve as a flip-flop. In the bipolar memory cells, the resistance value of the load resistors is very large so as to reduce the power consumption thereof. Therefore, the area of the load resistors occupied in a chip is very large and, in addition, an isolation between the cross-coupled transistors is required. Consequently, the bipolar memory cells are large in size, which results in low integration density, and therefore, a high manufacturing cost of the bipolar memory device.

In recent years, an $I^2L$ memory device has been developed. In an $I^2L$ memory cell, a pair of load transistors which serve as injectors are used instead of the above-mentioned large load resistors and, in addition, no isolation between transistors within a row is required. As a result, a high integration density and low manufacturing cost can be attained. It should be noted that, such an $I^2L$ memory device can be manufactured by using conventional bipolar technology.

Usually, one $I^2L$ memory cell comprises a pair of first and second transistors of a first conduction type, such as a pnp type, which serve as injectors, a pair of cross-coupled third and fourth transistors of a second conduction type, such as an npn type, which serve as a flip-flop and a pair of fifth and sixth transistors of the second conduction type for detecting and reversing the state of the flip-flop in the read and write mode, respectively. The third and fourth transistors are always in the reverse conducting mode, in other words, the emitters and collectors of these transistors are used as collectors and emitters, respectively. In addition, when the memory cell is non-selected, the fifth and sixth transistors are also in the reverse conducting mode. Contrary to this, when the memory cell is selected, the fifth and sixth transistors are in the forward conducting mode.

In the above-mentioned $I^2L$ memory cell, one of the third and fourth transistors is conductive, while the other is non-conductive. If the third transistor is conductive, injection currents of the first and second transistors are supplied to the collector and base of the third transistor, respectively. In order to change the cell information, the third transistor must be changed to non-conductive. This is done by supplying an emitter current larger than a write threshold current $I_{wth}$, and therefore, by bypassing the base current of the third transistor to the base current of the fifth transistor. In this case, the write threshold current $I_{wth}$ depends on the total injection current $I_{inj}$ which flows through a common emitter of the first and second transistors. In other words, when the injection current $I_{inj}$ is large, the write threshold current $I_{wth}$ is large.

On the other hand, sink currents, which are explained below, flow from a selected memory cell to non-selected memory cells. The sink currents increase the injection current $I_{inj}$ of the selected memory cell and, accordingly, increase the write threshold current $I_{wth}$, so that the speed of the write operation becomes slow.

In order to decrease the sink currents flowing from a selected memory cell into non-selected memory cells, a clamp circuit is provided in one known $I^2L$ memory device, disclosed in an article entitled "A 4K-bit Static $I^2L$ Memory" in IEEE Transactions on Electron Devices, Vol. ED-26, No. 6, June 1979. Each unit cell comprises a pair of injector transistors and a pair of cross-coupled transistors each having an additional collector for connection to a bit line. The clamp circuit comprises a plurality of pairs of clamp transistors, each connected to each of the pairs of bit lines. In a write mode, a high voltage is applied to the bases of the clamp transistors, so that sink currents flow into non-selected memory cells from the clamp transistors. However, in the conventional device, there is a problem in that it is difficult to determine the value of such a high voltage applied to the clamp transistors, since the quantity of sink currents flowing through a bit line depends on the states of the flip-flops of the memory cells, and, in addition, when the value of the voltage is very high, the write current cannot flow from the selected memory cell to one of the selected bit lines. In addition, such sink currents of non-selected memory cells which are not connected to a selected word line and selected bit line pair are supplied from the selected memory cell through half-selected memory cells which are connected to the selected word line, not to the selected bit line pair. As a result, the speed of the write operation is low and unstable.

It is a principal object of the present invention to provide a semiconductor integrated circuit memory device of an $I^2L$ type with high and stable write operation speed.

According to the present invention, there is provided a semiconductor integrated circuit memory device comprising: a plurality of word lines; a plurality of word drivers, each connected to one of the word lines; a plurality of hold lines; a plurality of pairs of bit lines; a plurality of bit drivers, each connected to one of the pairs of bit lines; a plurality of memory cells of integrated injection logic, wherein each of the said memory cells includes: injectors comprising a pair of first and second transistors of a first conduction type which have a common emitter connected to one of the said word lines; a flip-flop comprising a pair of cross-coupled third and fourth transistors of a second conduction type, connected to the first and second transistors, respectively; transistor means coupling the third and fourth transistors to respective ones of one of the pairs of bit lines; the third and fourth transistors being connected also to one of the said hold lines; and a clamp means comprising a plurality of clamping transistor means, each connected to one of the pairs of bit lines; and characterized in that the clamping transistor means are transistors pairs and by a control means for controlling the base potentials of the transistor pairs so as to clamp the potential of the first bit line of each pair of bit lines, through which a write current flows, to be lower than that of the second bit line of each pair of bit lines in response to a write enable signal and an input data signal; and also by a further clamp means for raising the potentials of a non-selected pair of the said pairs of bit lines with respect to those of a selected one of the said pairs of bit lines, the selected pair being selected by the said bit drivers. The potentials of the first bit lines should be as low as possible so as to increase the write current of a selected memory cell, while it is also preferable that the potentials of the second bit lines be as high as possible, so that sink currents of non-selected memory cells, which are, however, connected to selected bit line pairs, are completely supplied from the first clamp means, not from the selected memory cell. Therefore, the speed of the write operation is high and stable. It is also preferable that the potentials of the selected bit lines be as low as possible and that the potentials of the non-selected bit lines be as high as possible, so that sink currents of non-selected memory cells which are not connected to a selected word line and selected bit line pair are completely supplied from the further clamp means. Therefore, the further clamp means also assists the speed and stability of the write operation.

US Patent specification No. 4 078 261 discloses a memory circuit using flip-flop cells comprising dual-emitter transistors and resistor loads, the cells being coupled to a pair of bit conductors; means coupled between the bit conductors and a sense circuit isolate the sense circuit from the storage cell during a writing operation. In a writing operation one of the bit lines is held at a lower potential than the other bit line and one of the memory cell transistors conducts all the bit line current of the bit line at the lower voltage. Because the magnitude of voltage swings of the bit lines to change the storage state of a cell is reduced, the writing speed is improved.

The present invention will be more clearly understood from the following description with reference to the accompanying drawings, wherein:

Figure 1 is a circuit diagram illustrating an equivalent circuit of one I²L memory cell;

Figure 2 is a cross-sectional view of the I²L memory cell of Figure 1;

Figure 3 is a circuit diagram of two I²L memory cells of Fig. 1;

Figs. 4A and 4B are block diagrams of n I²L memory cells of Fig. 1;

Fig. 5 is a circuit diagram of four I²L memory cells of Fig. 1;

Fig. 6 is a block diagram illustrating a conventional I²L memory device;

Fig. 7 is a diagram showing potential levels for explaining the value of the clamp voltage $V_C$ of the clamp circuit CL of Fig. 6;

Fig. 8 is a circuit diagram illustrating an embodiment of the I²L memory device according to the present invention, and;

Fig. 9 is a timing diagram of the signals $V_{C1}$ and $V_{C2}$ of Fig. 8.

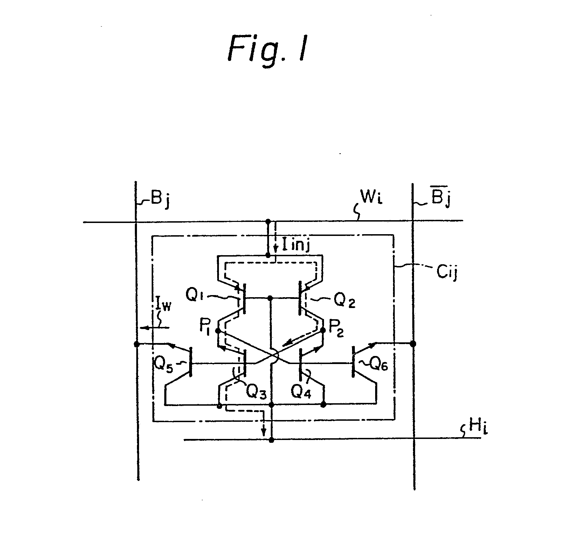

Referring to Fig. 1, which illustrates an equivalent circuit of one I²L memory cell, a memory cell $C_{ij}$ comprises a pair of transistors $Q_1$ and $Q_2$ of a pnp type which serve as injectors, a pair of transistors $Q_3$ and $Q_4$ of an npn type which are cross-coupled to each other and serve as a flip-flop, and a pair of transistors $Q_5$ and $Q_6$ of an npn type for detecting and reversing the state of the flip-flop in the read and write mode, respectively. The transistors $Q_1$ and $Q_2$ have a common emitter connected to a word line $W_i$ and collectors connected to collectors (which are represented as emitters in Fig. 1) of the transistors $Q_3$ and $Q_4$, respectively. The bases of the transistors $Q_1$ and $Q_2$, the emitters of the transistors $Q_3$ and $Q_4$, and the collectors of the transistors $Q_5$ and $Q_6$ are connected to a common hold line $H_i$. In addition, the emitters of the transistors $Q_5$ and $Q_6$ are connected to bit lines $B_j$ and $\overline{B}_j$, respectively.

The selection of the memory cell $C_{ij}$ is effected by raising the potential of the word line $W_i$ and by connecting the bit lines $B_j$ and $\overline{B}_j$ to data bit lines (not shown), to which current sources (not shown) are connected. The transistors $Q_3$ and $Q_4$ are in the reverse conducting mode, regardless of the selected or non-selected state of the memory cell $C_{ij}$. Contrary to this, the transistors $Q_5$ and $Q_6$ are in the forward conducting mode during the selected state of the memory cell $C_{ij}$, while the transistors $Q_5$ and $Q_6$ are in the reverse conducting mode during the non-selected state of the memory cell $C_{ij}$.

In Fig. 1, the transistors $Q_3$ and $Q_4$, are placed in the on and off state alternately. For example, when the transistor $Q_3$ is conductive, an injection current $I_{inj}$ is supplied to the transistor $Q_3$ as a base current and a collector current through the transistors $Q_2$ and $Q_1$, respectively. As a result, the transistor $Q_3$ is in a saturated state, so that the potential at $P_1$ is low and, accordingly, the transistor $Q_4$ is non-conductive. In order to change the information stored in the memory cell $C_{ij}$, the transistor $Q_3$ should be changed from conductive to non-conductive. This is done by supplying a write current $I_w$

larger than a write threshold current $I_{wth}$ to the emitter of the transistor $Q_5$, so that the base of the transistor $Q_5$ absorbs the base current of the transistor $Q_3$. As a result, the transistor $Q_3$ is changed from a saturated state to a non-saturated state, so that the potential at $P_1$ becomes high. Therefore, the transistor $Q_4$ becomes conductive and the potential at $P_2$ becomes low, so that the transistor $Q_3$ becomes non-conductive. That is, the state of the flip-flop formed by the transistors $Q_3$ and $Q_4$ is reversed.

In the above-mentioned write mode, the write threshold current $I_{wth}$ depends on the injection current $I_{inj}$. Therefore, the write threshold current $I_{wth}$ is large where the injection current $I_{inj}$ is large.

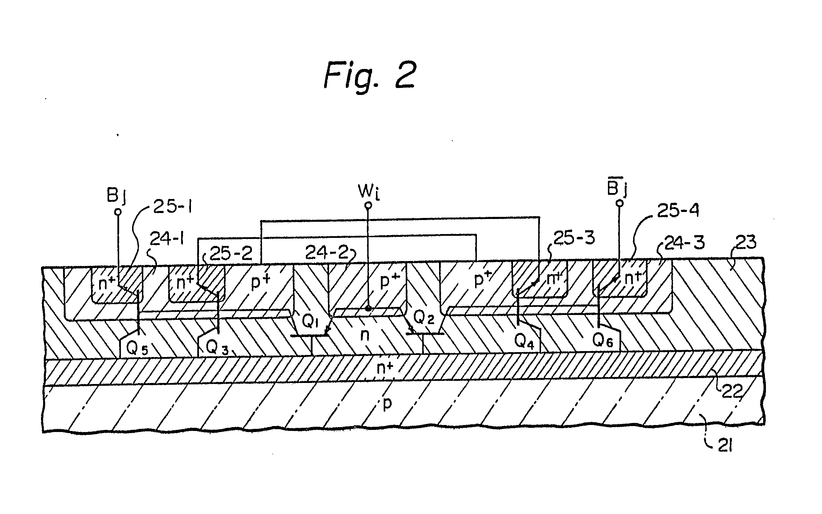

Fig. 2 is a cross-sectional view of the $I^2L$ memory cell of Fig. 1. In Fig. 2, an $n^+$-type buried layer 22, which serves as the hold line $H_i$ (Fig. 1), is formed in a p-type substrate 21 by using conventional diffusion technology. In addition, an n-type epitaxial layer 23 is formed on the buried layer 22 by using epitaxial technology. Further, in the epitaxial layer 23, $p^+$-type diffusion layers 24-1, 24-2 and 24-3 ar formed, and in addition, in the $p^+$-type diffusion layers 24-1 and 24-3, $n^+$-type diffusion layers 25-1, 25-2, 25-3, 25-4 are formed by using conventional diffusion technology. As illustrated in Fig. 2, the injection transistors $Q_1$ and $Q_2$ are of a lateral type, while the transistors $Q_3$ and $Q_5$ (and $Q_4$ and $Q_6$) are formed by one vertical transistor with multiple collectors. In the memory cell of Fig. 2, it should be noted that there is no resistor of high resistance and no isolation between the transistors $Q_1$ through $Q_6$, so that the memory cells can be formed in a high density.

Next, sink currents flowing into non-selected memory cells will be explained.

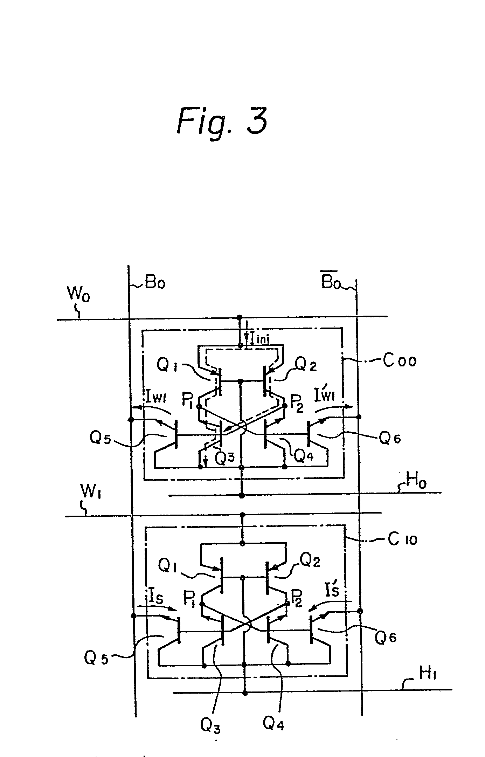

Fig. 3 is a circuit diagram of two $I^2L$ memory cells of Fig. 1 which are arranged in one column. In Fig. 3, when memory cells $C_{00}$ and $C_{10}$ are selected and non-selected, respectively, in other words, when the potentials of word lines $W_0$ and $W_1$ are high and low, respectively, the potentials of hold lines $H_0$ and $H_1$ are high and low, respectively. In addition, when the transistors $Q_3$ of both of the cells $C_{00}$ and $C_{10}$ are conductive, the transistors $Q_5$ of both of the cells $C_{00}$ and $C_{10}$ are conductive. In this case, the transistor $Q_5$ of the cell $C_{00}$ is in the forward conducting mode, while the transistor $Q_5$ of the cell $C_{10}$ is in the reverse conducting mode. Therefore, a current $I_{W1}$ which is a part of an injection current $I_{inj}$ flows from the transistor $Q_5$ of the cell $C_{00}$ to a bit line $B_0$, while a sink current $I_s$ flows from the bit line $B_0$ through the transistor $Q_5$ of the cell $C_{10}$ to the hold line $H_1$. If the current $I_{W1}$ serves as a write current, the sink current $I_s$ increases the current $I_W$ so that the speed of write operation becomes high.

Contrary to above, in the non-selected cell $C_{10}$, when the transistors $Q_5$ and $Q_6$ are non-conductive and conductive, respectively, a sink current $I_s'$ flows from a bit line $\overline{B}_0$ through the

transistor $Q_6$ of the cell $C_{10}$ to the hold line $H_1$. In this case, the transistor $Q_6$ of the cell $C_{00}$ is in the forward conducting mode, and therefore, a current $I_{W1}'$ flows from the transistor $Q_6$ to a bit line $\overline{B}_0$, while a sink current $I_s'$ flows from the bit line $B_0$ through the transistor $Q_6$ of the cell $C_{10}$ to the hold line $H_1$, so that the injection current $I_{inj}$ of the cell $C_{00}$ is increased. As a result, the write threshold current $I_{wth}$, which depends on the injection current $I_{inj}$, is also increased, and therefore, the speed of the write operation becomes slow.

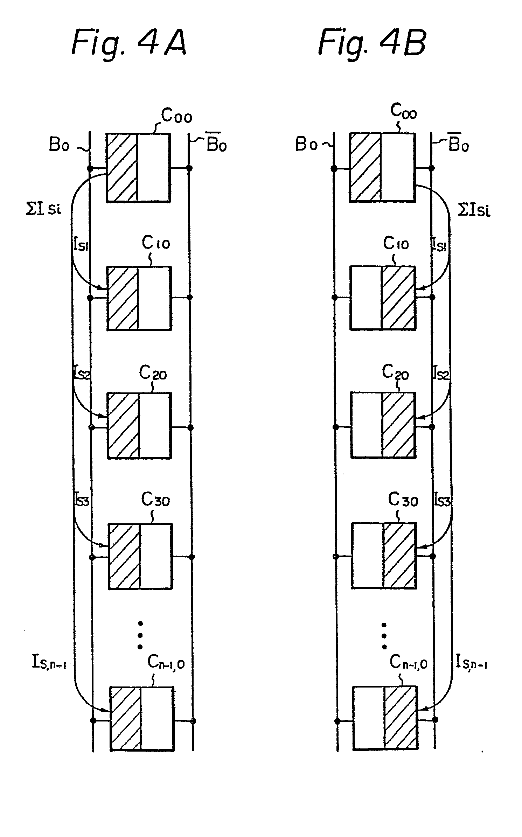

Figs. 4A and 4B are block diagrams of n $I^2L$ memory cells of Figure 1 which are arranged in one column. In Figs. 4A and 4B, in a memory cell wherein the left-half portion thereof is shaded, the transistors $Q_3$ and $Q_4$ (Fig. 1) are conductive and non-conductive, respectively. Contrary to this, in a memory cell wherein the right-half portion thereof is shaded, the transistors $Q_3$ and $Q_4$ are non-conductive and conductive, respectively. In Figs. 4A and 4B, the memory cell $C_{00}$ is selected and the others are non-selected.

As illustrated in Fig. 4A, a total sink current $\Sigma I_{si}$ flows into the selected memory cell $C_{00}$, that is, into the on-state side transistor $Q_5$ (Fig. 1) thereof, so that the total sink current is added to a write current for the selected $C_{00}$ and, accordingly, the speed of write operation becomes high. Contrary to this, in Fig. 4B, a total sink current $\Sigma I_{si}$ flows into the selected memory cell $C_{00}$, that is, into the off-state side transistor $Q_6$ (Fig. 1) thereof, so that the injection current of the selected memory cell $C_{00}$ is increased and, accordingly, the write threshold current is increased. As a result, the speed of write operation is decreased, if the write current is retained at a predetermined level. Thus, the speed of write operation for a selected memory cell depends on the states of the flip-flops of non-selected memory cells.

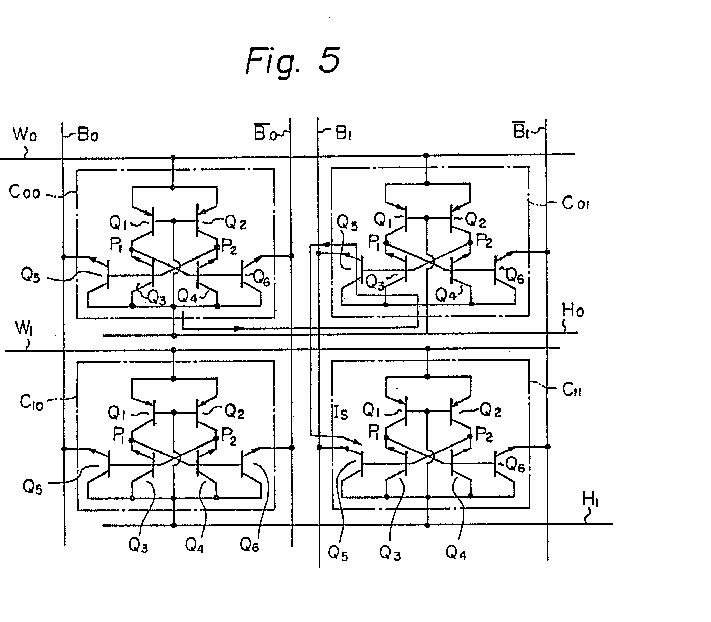

Figure 5 is a circut diagram of four $I^2L$ memory cells of Figure 1 which are arranged in a 2 row, 2 column matrix form. In Figure 5, only one memory cell $C_{00}$ is selected, while the others are non-selected. However, in this case, the potential of a word line $W_0$ to which the non-selected memory cell $C_{01}$ belongs is higher, even though bit lines $B_1$ and $\overline{B}_1$ are not selected, in other words, no write current flows through the bit lines $B_1$ and $\overline{B}_1$. Such a non-selected memory cell $C_{01}$ connected to the high potential word line is defined as a half-selected memory cell. If the transistor $Q_5$ of the non-selected memory cell $C_{11}$ is conductive, the transistors $Q_5$ of the memory cells $C_{01}$ and $C_{11}$ are in the forward and reverse conducting modes, respectively, since the potential of the hold line $H_0$ is higher than that of the hold line $H_1$. Therefore, a sink current $I_s$ flows into the transistor $Q_5$ of the non-selected memory cell $C_{11}$. As illustrated in Fig. 5, the sink current $I_s$ is supplied from the selected cell $C_{00}$, through the half-selected cell $C_{01}$, to the non-selected cell $C_{11}$.

Such a sink current through a half-selected memory cell is small, however, usually, there is a large number of such non-selected memory cells in a memory device. For example, in a 1024 bit (32 rows, 32 columns) memory device, there are $(32-1)^2$ of such non-selected memory cells. Therefore, the total sink current through half-selected memory cells is large, which also increases the injection current $I_{inj}$ of a selected memory cell.

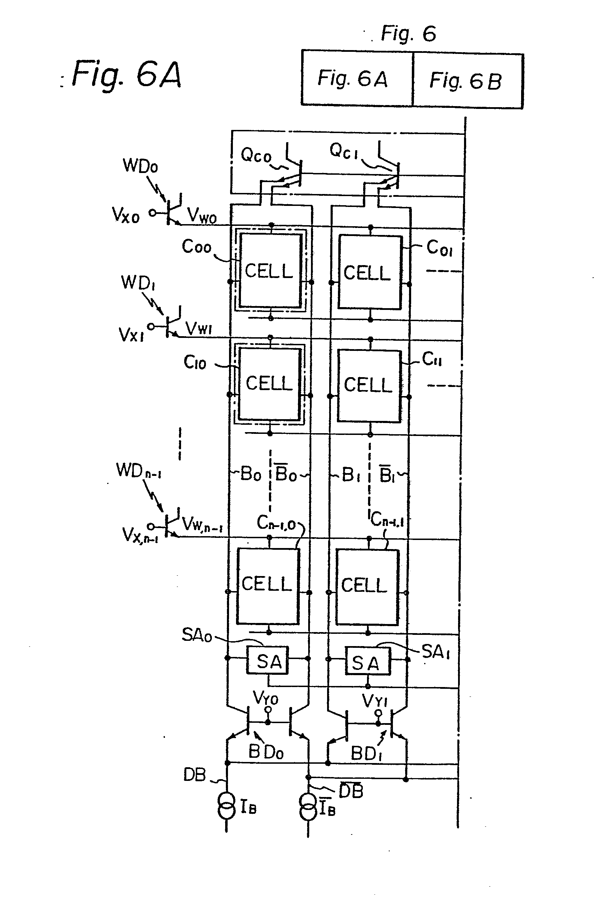

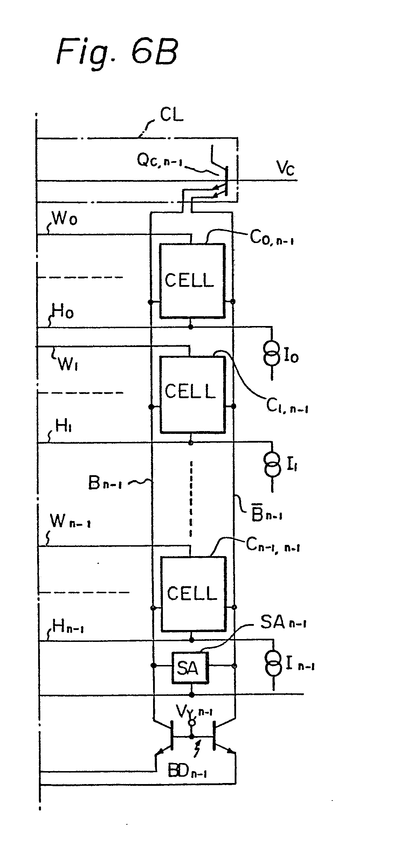

Fig. 6 is a block diagram illustrating a conventional $I^2L$ memory device. In Fig. 6, a memory array which is comprised of memory cells $C_{ij}$ (i, j=0, 1, . . . , N—1), which are arranged in an n row, n column matrix, is shown. Each of the memory cells $C_{ij}$ can be selected by supplying row selection signals $V_{X0}$ through $V_{X,n-1}$ to word decoders $WD_0$ through $WD_{n-1}$ and by supplying column selection signals $V_{Y0}$ through $V_{Y,n-1}$ to bit drivers $BD_0$ through $BD_{n-1}$. Sense amplifiers indicated by the references $SA_0$, . . . , $SA_{n-1}$ detect the data stored in the memory cells.

In the above-mentioned device, a clamp circuit CL is provided so as to supply sink currents into non-selected memory cells. Therefore, an injection current in a selected memory cell can be stable. For example, when the potentials of only the signals $V_{X0}$ and $V_{Y0}$ are high, the memory cell $C_{00}$ is selected and the memory cells $C_{01}$, $C_{02}$, . . . , $C_{0,n-1}$, which belong to the word line $W_0$, are half-selected. In addition, the other memory cells are non-selected. A clamp voltage $V_C$ of the clamp circuit CL should be determined between two values which will now be explained.

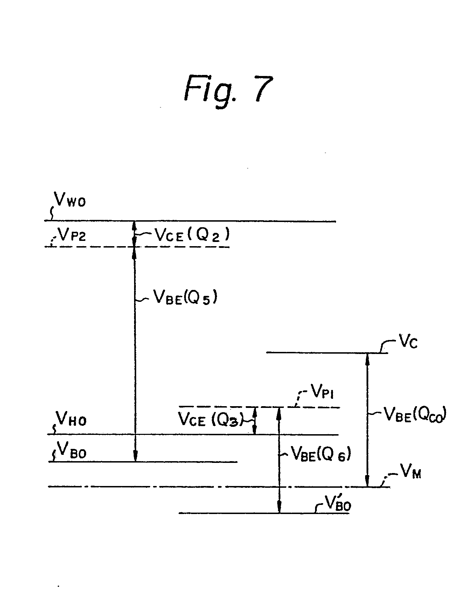

Fig. 7 is a diagram showing potential levels, for explaining the value of the clamp voltage $V_C$ of the clamp circuit CL of Fig. 6. In Fig. 7, $V_{W0}$ and $V_{H0}$ indicate the potentials of the word line $W_0$ and the hold line $H_0$, and; $V_{P1}$ and $V_{P2}$ indicate the potentials at $P_1$ and $P_2$ (see, Fig. 1), respectively, of the memory cell $C_{00}$, which potentials are represented as follows.

$$V_{P1}=V_{H0}+V_{CE}(Q_3)$$

$$V_{P2}=V_{W0}-V_{CE}(Q_2)$$

where $V_{CE}$ $(Q_3)$ and $V_{CE}(Q_2)$ are collector-emitter voltages of the transistors $Q_3$ and $Q_2$ (Fig. 1), respectively. In this case, the transistors $Q_3$ and $Q_4$ (Fig. 1) of the cell $C_{00}$ are conductive and nonconductive, respectively.

In addition, the potential $V_{B0}$ of the bit line $B_0$ should satisfy the following formula, so that the write current $I_W$ can flow from the transistor $Q_5$ (Fig. 1) into the bit line $B_0$.

$$V_{B0}=V_{P2}-V_{BE}(Q_5)$$

where $V_{BE}(Q_5)$ is a base-emitter voltage of the transistor $Q_5$.

On the other hand, the potential $V_{B0}'$ of the bit line $\overline{B}_0$ should satisfy the following formula, so that no sink current can flow from the transistor $Q_6$ (Fig. 1) of the selected cell $C_{00}$ to non-selected memory cells.

$$V_{B0}'=V_{P1}-V_{BE}(Q_6)$$

where $V_{BE}(Q_6)$ is a base-emitter voltage of the transistor $Q_6$.

Therefore, for example, the clamp voltage $V_C$ is caused to be $V_M+V_{BE}(Q_{C0})$, where $V_M$ is $(V_{B0}-V_{B0}')/2$ and $V_{BE}$ is a base-emitter voltage of the transistor $Q_{C0}$ of the clamp circuit CL. Thus, a large write current can flow from the selected memory cell and, in addition, sink currents are supplied to the non-selected memory cells from the clamp circuit CL, not from the selected memory cell. However, since the potential $V_{BE}(Q_5)$ or $V_{BE}(Q_6)$ depends on whether or not a write current flows through the transistor $Q_5$ or $Q_6$, in other words, the potential $V_{BE}(Q_5)$ is larger than the potential $V_{BE}(Q_6)$, the difference between the potentials $V_{B0}$ and $V_{B0}'$ is small, and accordingly, it is difficult to determine the clamp voltage $V_C$ at an appropriate level. As a result, the variation of speed of the write operation may be large. In addition, it is difficult to reduce the increase of the injection current of the selected memory cell due to the presence of sink currents through the half-selected memory cells.

In the present invention, the potential of a bit line of a selected bit line pair through which a write current flows is clamped as low as possible, while the potential of the other of the selected bit line pair through which a write current does not flow is clamped as high as possible, so that sink currents towards other non-selected memory cells connected to the selected bit line pair are not supplied from the selected memory cell. In addition, the potentials of bit lines of non-selected bit pairs are clamped as high as possible, so that sink currents towards non-selected memory cells connected to the non-selected bit pairs are not supplied from the selected memory cell.

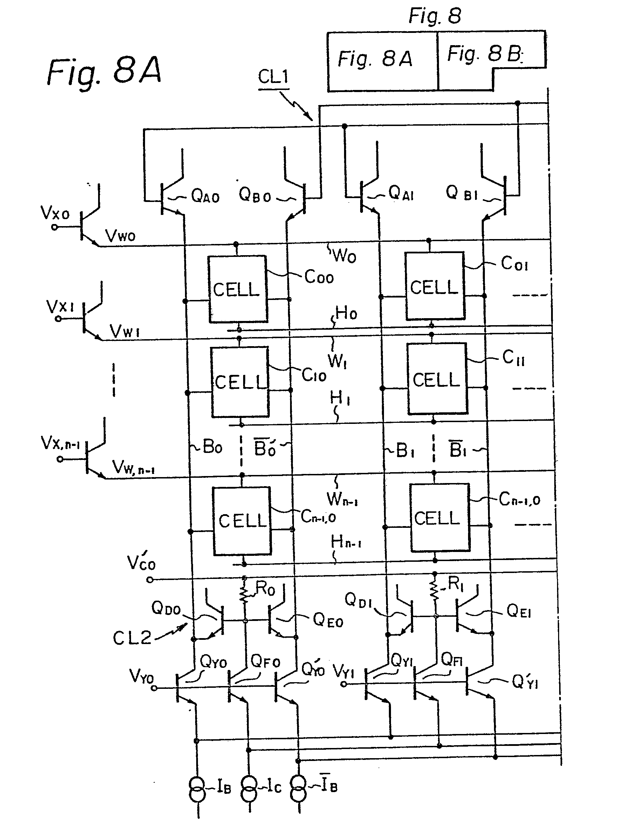

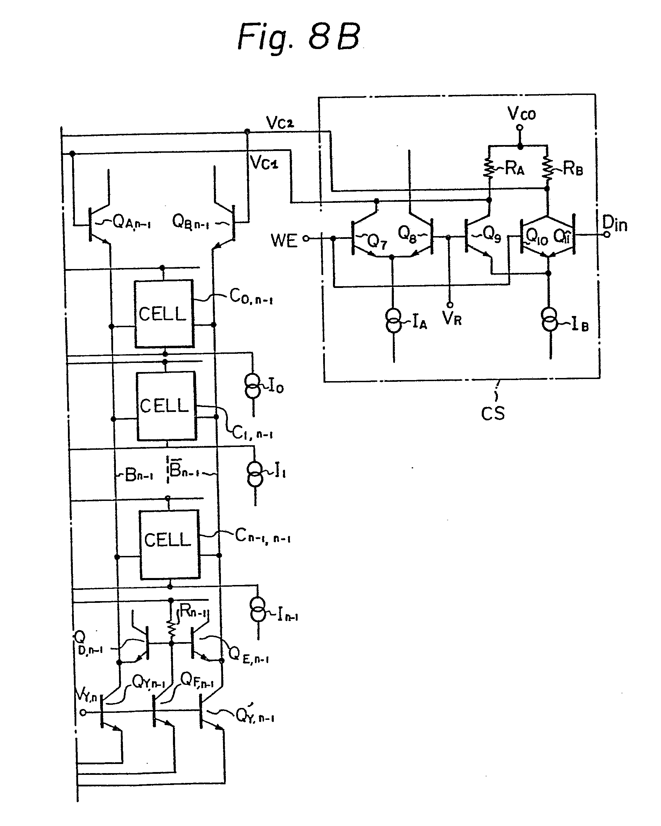

Fig. 8 is a circuit diagram illustrating an embodiment of the $I^2L$ memory device according to the present invention. The elements illustrated in Fig. 8 which are identical to those of Fig. 6 are denoted by the same reference numerals. In Fig. 8, a clamp circuit CL1, a current switching circuit CS for controlling the clamp circuit CL1 and another clamp circuit CL2 are provided. In addition, the potentials of selection signals $V_{X0}$ and $V_{Y0}$ are high and the potentials of the other selection signals are low, in other words, a memory cell $C_{00}$ is selected, memory cells $C_{01}$ through $C_{0,n-1}$ are half-selected and the other memory cells are non-selected.

The clamp circuit CL1 and the current switching circuit CS of Fig. 8 will now be explained in more detail. The clamp circuit CL1 comprises transistor pairs $Q_{A0}$, $Q_{B0}$; $Q_{A1}$, $Q_{B1}$;

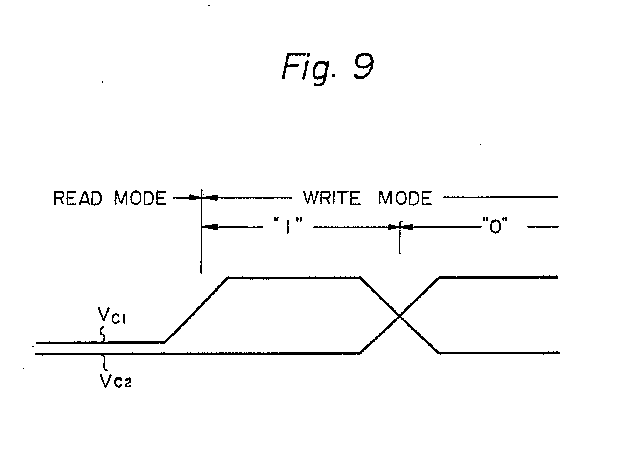

...; $Q_{A,n-1}$, $Q_{B,n-1}$, connected to the pairs of bit lines $B_0$, $\overline{B}_0$; $B_1$, $\overline{B}_1$; ...; $B_{n-1}$, $B_n$, respectively. The voltage $V_{C1}$ of the bases of the transistors $Q_{A0}$, $Q_{A1}$, ..., $Q_{A,n-1}$ and the voltage $V_{C2}$ of the bases of the transistors $Q_{B0}$, $Q_{B1}$, ..., $Q_{B,n-1}$ are controlled by the current switching circuit CS. In the current switching circuit CS, transistors $Q_7$ and $Q_8$ form a current switch controlled by an inverted signal of a write enable signal WE and a reference voltage $V_R$, while transistors $Q_9$, $Q_{10}$ and $Q_{11}$ form another current switch controlled by the reference voltge $V_R$, the signal $\overline{WE}$ and an input data signal $D_{in}$. During a read mode, in which the potential of the signal $\overline{WE}$ is higher than the reference voltage $V_R$, the transistors $Q_7$ and $Q_{10}$ are conductive and the others are non-conductive, so that currents $I_A$ and $I_B$ flow through resistors $R_A$ and $R_B$, which are connected to a line whose potential is $V_{C0}$ respectively. As a result, the clamp voltages $V_{C1}$ and $V_{C2}$ are both low, as illustrated in Fig. 9.

In a write mode in which the potentials of the signals $\overline{WE}$ and $D_{in}$ are lower and higher, respectively, than the reference voltage $V_R$, the transistors $Q_8$ and $Q_{11}$ are conductive and the others are non-conductive, so that the current $I_A$ flows through the transistor $Q_8$, not through the resistor $R_A$, and the current $I_B$ flows through the resistor $R_B$. As a result, the clamp voltages $V_{C1}$ and $V_{C2}$ are high and low, respectively, as illustrated in Fig. 9.

Contrary to above, in another write mode in which the potentials $\overline{WE}$ and $D_{in}$ are lower than the reference voltage $V_R$, the transistors $Q_8$ and $Q_9$ are conductive and the others are non-conductive, so that the currents $I_A$ and $I_B$ flow through the transistors $Q_8$ and $Q_9$, respectively, not through the resistor $R_B$. As a result, the clamp voltages $V_{C1}$ and $V_{C2}$ are low and high, respectively, as illustrated in Fig. 9.

It should be noted that the difference between the voltages $V_{c1}$ and $V_{c2}$ can be increased by raising the potential $V_{C0}$ of the circuit CS, and the values of the resistors $R_A$ and $R_B$. Therefore, the write current can be increased, since a current is not limited by the off-state clamp transistor, such as $Q_{A0}$, to the bit line $B_0$. In addition, sink currents of non-selected memory cells which are connected to selected bit line $B_0$ is completely supplied from the on-state clamp transistor $Q_{A1}$, in other words, no sink currents flows from the off-state transistor of the selected memory cell $C_{00}$.

Next, the clamp circuit CL2 of Fig. 8 will be explained in more detail. The clamp circuit CL2 comprises pairs of transistors $Q_{D0}$, $Q_{E0}$; $Q_{D1}$, $Q_{E1}$; ...; $Q_{D,n-1}$, $Q_{E,n-1}$, connected to bit lines $B_0$, $\overline{B}_0$; $B_1$, $\overline{B}_1$; ...; $B_{n-1}$, $\overline{B}_{n-1}$, respectively. The bases of the transistors $Q_{D0}$, $Q_{E0}$; $Q_{D1}$, $Q_{E1}$; ...; $Q_{D,n-1}$, $Q_{E,n-1}$ are connected to resistors $R_0$, $R_1$, ..., $R_{n-1}$, respectively, which are connected to a line whose potential is $V_{C0}'$, and to driving transistors $Q_{F0}$, $Q_{F1}$, ..., $Q_{F,n-1}$. The driving transistors which are associated with transistors $Q_{Y0}$, $Q_{Y0}'$; $Q_{Y1}$, $Q_{Y1}'$; ...; $Q_{Y,n-1}$, $Q_{Y,n-1}'$, which form bit drivers, are controlled by column selection signals $V_{Y0}$, $V_{Y1}$, ..., $V_{Y,n-1}$. When the potential of the signal $V_{Y0}$ is high and the others are low, a current $I_C$ flows through the resistor $R_0$ and the transistor $Q_{F0}$, so that the potential of the bases of the transistors $Q_{D0}$ and $Q_{E0}$ are low, and the potentials of the transistors $Q_{D1}$, $Q_{E1}$, $Q_{D2}$, $Q_{E2}$, ..., $Q_{D,n-1}$, $Q_{E,n-1}$ are high. As a result, the potentials of the bit lines $B_0$ and $\overline{B}_0$ are low, and the potentials of the other bit lines are high. Therefore, sink currents of non-selected memory cells which are not connected to the selected word line $W_0$ and to the selected bit lines $B_0$ and $\overline{B}_0$ are supplied from the transistors $Q_{D1}$, $Q_{E1}$, $Q_{D2}$, $Q_{E2}$, ..., $Q_{D,n-1}$, $Q_{E,n-1}$. Of course, some of such sink currents are supplied from the clamp circuit CL1. However, in a selected column, one of the potentials of the bit lines $B_0$ and $\overline{B}_0$ is caused to be high by the transistor $Q_{A0}$ or $Q_{B0}$ of the clamp circuit CL1.

As explained hereinbefore, the semiconductor integrated circuit device according to the present invention has an advantage in that the speed of write operation is high and stable, since sink currents of non-selected memory cells are completely supplied from the clamp circuits and, in addition, no current is supplied from the clamp circuits to a selected bit line through which a write current flows.

In our copending application No. 80302482.7 (EP—A—23792), we have disclosed and claimed a semiconductor memory device including integrated injection logic memory cells, and further including a plurality of clamping means, each connected to one pair of bit lines, and means for controlling the clamping means in accordance with a write enable signal to alter the lower of the two potentials of a selected pair of bit lines so that this lower potential is higher during the read mode than it is during the write mode. This reduces the difference in potential between the selected bit lines and thereby increases the speed of the reading operation. In one embodiment, there is also described an additional clamping circuit and switching transistor for each column, the effect of which if to increase the potentials of non-selected bit lines and to supply sink currents of non-selected memory cells of other columns from the transistors of the additional clamping circuits for those columns.

## Claims

1. A semiconductor integrated circuit memory device comprising: a plurality of word lines ($W_0$, $W_1$, ..., $W_{n-1}$; Fig. 8); a plurality of word drivers, each connected to one of the word lines; a plurality of hold lines ($H_0$, $H_1$, ..., $H_{n-1}$); a plurality of pairs of bit lines ($B_0$, $\overline{B}_0$; $B_1$, $\overline{B}_1$; ...; $B_{n-1}$, $\overline{B}_{n-1}$); a plurality of bit drivers ($Q_{y0}$, $Q_{y0}'$, $Q_{y1}$, $Q_{y1}'$; ...; $Q_{yn-1}$, $Q_{yn-1}'$), each connected to one of the said pairs of bit lines; a plurality of memory cells of integrated injection logic $C_{00}$, $C_{01}$, ..., $C_{n-1,n-1}$), wherein each of the said memory cells includes: injectors comprising a pair of first and second transistors ($Q_1$, $Q_2$ Fig. 1) of a first conduction type which have a common emitter connected to one of the said word lines ($W_j$); a flip-flop comprising a pair of cross-coupled third and fourth transistors ($Q_3$, $Q_4$) of a second conduction type, connected to the first and second transistors, respectively; transistor means ($Q_5$, $Q_6$) coupling the third and fourth transistors to respective ones of one of the pairs of bit lines ($B_j$, $\overline{B}_j$); the third and fourth transistors being connected also to one of the said hold lines ($H_j$); and a clamp means (CL1) comprising a plurality of clamping transistor means, each connected to one of the pairs of bit lines; and characterized in that the clamping transistor means are transistor pairs and by a control means (CS) for controlling the base potentials of the transistor pairs ($Q_{A0}$, $Q_{B0}$; $Q_{A1}$, $Q_{B1}$; ...; $Q_{A,n-1}$, $Q_{B,n-1}$) so as to clamp the potential of the first bit line of each pair of bit lines, through which a write current flows, to be lower than that of the second bit line of each pair of bit lines in response to a write enable signal (WE) and input data signal ($D_{in}$); and also by a further clamp means (CL2) for raising the potentials of a non-selected pair of the said pairs of bit lines with respect to those of a selected one of the said pairs of bit lines, the selected pair being selected by the said bit drivers.

2. A device according to claim 1, wherein the said further clamp means comprises: a plurality of pairs of clamp transistors ($Q_{D0}$, $Q_{E0}$; $Q_{D,n-1}$, $Q_{E,n-1}$), each connected to a different one of the said pairs of bit lines; a plurality of resistors ($R_0$, ...; $R_{n-1}$), each connected to the bases of one of the said pairs of clamp transistors of the further clamp means; a plurality of driving transistors ($Q_{F0} \ldots Q_{F,n-1}$), each connected to one of the said resistors and to one of the said bit drivers; and a current source ($I_c$) supplying a current to each of the said driving transistors.

3. A device according to claim 1 or 2 wherein the said control means comprises a current switching circuit (CS) for selectively clamping the bases of the transistors of the first clamp means in response to the write enable signal and the input data signal.

4. A device according to claim 3, wherein the said current switching circuit comprises: a first current switch comprising two transistors ($Q_7$, $Q_8$) controlled by the said write enable signal (WE) and a reference voltage ($V_R$), respectively; a second current switch comprising three transistors ($Q_9$, $Q_{10}$, $Q_{11}$) controlled by the said reference voltage ($V_R$), the said write enable signal (WE) and the said input data signal ($D_{in}$), respectively; first and second current sources ($I_A$, $I_B$) for supplying currents to the first and second current switches; a first resistor ($R_A$) connected to a transistor ($Q_7$) in the first current switch and one transistor ($Q_9$) in the second current switch; and a second transistor ($R_B$) connected to the other two transistors ($Q_{10}$, $Q_{11}$) of the second current switch.

## Revendications

1. Dispositif de mémoire à circuit intégré semiconducteur comprenant: plusieurs lignes de mot ($W_0$, $W_1$, ..., $W_{n-1}$; Figure 8); plusieurs éléments de commande de mot connectés chacun à l'une des lignes de mot; plusieurs lignes de maintien ($H_0$, $H_1$, ..., $H_{n-1}$); plusieurs paires de lignes de bit ($B_0$, $\overline{B}_0$; $B_1$, $\overline{B}_1$; ...; $B_{n-1}$, $\overline{B}_{n-1}$); plusieurs éléments de commande de bit ($Q_{y0}$, $Q_{y0}'$, $Q_{y1}$, $Q_{y1}'$; ...; $Q_{yn-1}$, $Q_{yn-1}'$) connectés chacun à l'une desdites paires de lignes de bit; plusieurs cellules de mémoire à logique à injection intégrée ($C_{00}$, $C_{01}$, ..., $C_{n-1,n-1}$), où chacune desdites cellules de mémoire comporte: des injecteurs comprenant une paire de transistors formée d'un premier et d'un deuxième transistor ($Q_1$, $Q_2$; Figure 1) d'un premier type de conduction qui possèdent un émetteur commun connecté à l'une desdites lignes de mot ($W_j$); une bascule comprenant une paire de transistors formée d'un troisième et d'un quatrième transistor ($Q_3$, $Q_4$) connectés en croix d'un deuxième type de conduction, qui sont connectés respectivement aux premier et deuxième transistors; un moyen à transistors ($Q_5$, $Q_6$) couplant les troisième et quatrième transistors à des lignes respectives de l'une des paires de lignes de bit ($B_j$, $\overline{B}_j$); les troisième et quatrième transistors étant connectés également à l'une desdites lignes de maintien ($H_j$); et un moyen de verrouillage (CL1) comprenant plusieurs moyens à transistors de verrouillage connectés chacun à l'une des paires de lignes de bit; et caractérisé en ce que les moyens à transistors de verrouillage sont des paires de transistors et par un moyen de commande (CS) qui commande les potentiels de base des paires de transistors ($Q_{A0}$, $Q_{B0}$; $Q_{A1}$, $Q_{A1}$, ...; $Q_{A,n-1}$, $Q_{B,n-1}$) de manière à verrouiller le potentiel de la première ligne de bit de chaque paire de lignes de bit, dans laquelle un courant d'écriture passe, sur un niveau inférieur à celui de la deuxième ligne de bit de chaque paire de lignes de bit en réponse à un signal de validation d'écriture (WE) et à un signal de donnée d'entrée ($D_{in}$); et également par un moyen de verrouillage supplémentaire (CL2) servant à élever les potentiels d'une paire non sélectionnée desdites paires de lignes de bit relativement aux potentiels d'une paire sélectionnée desdites paires de lignes de bit, la paire sélectionnée étant sélectionnée par lesdits éléments de commande de bit.

2. Dispositif selon la revendication 1, où ledit moyen de verrouillage supplémentaire comprend: plusieurs paires de transistors de verrouillage ($Q_{D0}$, $Q_{E0}$; $Q_{D,n-1}$, $Q_{E,n-1}$) connectés chacun à l'une, différente, desdites paires de lignes de bit; plusieurs résistances ($R_0$, ..., $R_{n-1}$) connectées chacune aux bases de l'une desdites paires de transistors de verrouillage du moyen de verrouillage supplémentaire;

plusieurs transistors de commande ($Q_{F0}$, ..., $Q_{F,n-1}$) connectés chacun à l'une desdites résistances et à l'un desdits éléments de commande de bit; et une source de courant ($I_c$) délivrant un courant à chacun desdits transistors de commande.

3. Dispositif selon la revendication 1 ou 2, où ledit moyen de commande comprend un circuit de commutation de courant (CS) servant à verrouiller sélectivement les bases des transistors du premier moyen de verrouillage en réponse au signal de validation d'écriture et au signal de donnée d'entrée.

4. Dispositif selon la revendication 3, où ledit circuit de commutation de courant comprend: un premier commutateur de courant comprenant deux transistors ($Q_7$, $Q_8$) commandés respectivement par ledit signal de validation d'écriture (WE) et un potentiel de référence ($V_R$); un deuxième commutateur de courant comprenant trois transistors ($Q_9$, $Q_{10}$, $Q_{11}$) commandés respectivement par ledit potentiel de référence ($V_R$), ledit signal de validation d'écriture (WE) et ledit signal de donnée d'entrée ($D_{in}$); une première et une deuxième source de courant ($I_A$, $I_B$) servant à délivrer des courants aux premier et deuxième commutateurs de courant; une première résistance ($R_A$) connectée à un transistor ($Q_7$) du premier commutateur de courant et à un deuxième transistor ($Q_9$) du deuxième commutateur de courant; et une deuxième résistance ($R_B$) connectée aux deux autres transistors ($Q_{10}$, $Q_{11}$) du deuxième commutateur de courant.

**Patentansprüche**

1. Integrierte Halbleiterspeichereinrichtung mit: einer Anzahl von Wortleitungen ($W_0$, $W_1$, ..., $W_{n-1}$; Fig. 8); einer Anzahl von Worttreibern, die jeweils mit einer der Wortleitungen verbinden sind; einer Anzahl von Halteleitungen ($H_0$, $H_1$, ..., $H_{n-1}$); einer Anzahl von Paaren von Bitleitungen ($B_0$, $\overline{B}_0$; $B_1$, $\overline{B}_1$; ...; $B_{n-1}$, $\overline{B}_{n-1}$); einer Anzahl von Bittreibern ($Q_{y0}$, $Q_{y0}'$, $Q_{y1}$, $Q_{y1}'$; ...; $Q_{yn-1}$, $Q_{yn-1}'$), die jeweils mit einem der genannten Paare von Bitleitungen verbunden sind; einer Anzahl von integrierten injektionslogischen Speicherzellen ($C_{00}$, $C_{01}$, ..., $C_{n-1,n-1}$), bei welcher jede Speicherzelle umfaßt: Injektoren, die ein Paar aus einem ersten und einem zweiten Transistor ($Q_1$, $Q_2$ Fig. 1) von einem ersten Leitfähigkeitstyp umfassen, welche einen gemeinsam mit einer der genannten Wortleitungen ($W_j$) verbundenen Emitter haben; ein Flipflop, das ein Paar von kreuzweise gekoppelten dritten und vierten Transistoren ($Q_3$, $Q_4$) von einem zweiten Leitfähigkeitstyp umfaßt, welche mit den ersten bzw. zweiten Transistoren verbunden sind; Transistoreinrichtungen ($Q_5$, $Q_6$), welche die dritten und vierten Transistoren mit entsprechenden Leitungen von einem der Paare von Bitleitungen ($B_j$, $\overline{B}_j$) verbinden; und dritten und vierten Transistoren, welche ebenfalls mit einer der genannten Halteleitungen ($H_i$) verbunden sind; und eine Klammereinrichtung (CL1), die eine Anzahl von Klammertransistoreinrichtungen umfaßt, von denen jede mit einer Leitung der Paare von Bitleitungen verbunden ist, dadurch gekennzeichnet, daß die Klammertransistoreinrichtung aus Transistorpaaren besteht,

und durch einer Steuereinrichtung (CS) zur Steuerung des Basispotentials der Transistorpaare ($Q_{A0}$, $Q_{B0}$; $Q_{A1}$, $Q_{B1}$; ...; $Q_{A,n-1}$, $Q_{B,n-1}$), um das Potential der ersten Bitleitung von jedem Paar von Bitleitungen, durch welche ein Schreibstrom fließt, in Abhängigkeit von einem Schreibaktivierungssignal (WE) und einem Eingangsdatensignal ($D_{in}$) so zu klammern, daß es niedriger als dasjenige der zweiten Bitleitung von jedem Paar von Bitleitungen ist;

und ferner durch eine Klammereinrichtung (CL2) zur Erhöhung des Potentials eines nicht ausgewählten Paares von den genannten Paaren von Bitleitungen in bezug auf dasjenige von einem ausgewählten der genannten Paare von Bitleitungen, wobei das ausgewählte Paar durch die genannten Bittreiber ausgewählt wird.

2. Einrichtung nach Anspruch 1, bei welcher die genannte weitere Klammereinrichtung umfaßt: eine Anzahl von Paaren von Klammertransistoren ($Q_{D0}$, $Q_{E0}$; $Q_{D,n-1}$, $Q_{E,n-1}$), die jeweils mit einer verschiedenen von den genannten Paaren von Bitleitungen verbunden sind; einer Anzahl von Widerständen ($R_0$, ...; $R_{n-1}$), die jeweils mit den Basen eines Paares der Klammertransistoren der weiteren Klammereinrichtung verbunden sind; eine Anzahl von Treibertransistoren ($Q_{F0}$ ... $Q_{F,n-1}$, die jeweils mit einem der genannten Widerstände und mit einem der genannten Bittreiber verbunden sind; und eine Stromquelle ($I_c$), welche jedem der genannten Treibertransistoren einen Strom liefert.

3. Einrichtung nach Anspruch 1 oder 2, bei welcher die genannte Steuereinrichtung einen Stromschaltkreis (CS) zur wahlweisen Klammerung der Basen der Transistoren der ersten Klammereinrichtung in Abhängigkeit von dem Schreibaktivierungssignal und dem Eingangsdatensignal umfaßt.

4. Einrichtung nach Anspruch 3, bei welcher der genannte Stromschaltkreis umfaßt: einen ersten Stromschalter, der zwei Transistoren ($Q_7$, $Q_8$) umfaßt, die von dem genannten Schreibaktivierungssignal (WE) bzw. einer Referenzspannung ($V_R$) gesteuert werden; einem zweiten Stromschalter, der drei Transistoren ($Q_9$, $Q_{10}$, $Q_{11}$) umfaßt, die von der genannten Referenzspannung ($V_R$), dem Schreibaktivierungssignal (WE) bzw. dem genannten Eingangsdatensignal ($D_{in}$) gesteuert werden; erste und zweite Stromquellen ($I_A$, $I_B$) zur Lieferung von Strömen zu den ersten und den zweiten Stromschaltern; einen ersten Widerstand ($R_A$), der mit einem Transistor ($Q_7$) in dem ersten Stromschalter und einem Transistor ($Q_9$) in dem zweiten Strom-

schalter verbunden ist; und einen zweiten Widerstand ($R_B$), der mit den anderen beiden

Transistoren ($Q_{10}$, $Q_{11}$ des zweiten Stromschalters verbunden ist.

# Fig. I

*Fig. 2*

## Fig. 3

# Fig. 4A

# Fig. 4B

0 023 408

# Fig. 5

5

*Fig. 6A*

*Fig. 6*

| *Fig. 6A* | *Fig. 6 B* |
|---|---|

*Fig. 6B*

## Fig. 7

Fig. 8

| Fig. 8A | Fig. 8 B |

Fig. 8A

# Fig. 8B

# Fig. 9

READ MODE $\longrightarrow$ WRITE MODE $\longrightarrow$

"1" $\longrightarrow$ "O" $\longrightarrow$

$V_{C1}$

$V_{C2}$